# EUROPEAN PATENT SPECIFICATION

(11) **EP 2 416 249 B1**
(45) Date of publication and mention of the grant of the patent: **24.09.2014**
(21) Application number: 09842570.5
(22) Date of filing: 31.03.2009
(51) Int. Cl.: G06F 11/22, G06F 11/263, G01R 31/319, G01R 33/09, B82Y 25/00

(54) **SELF-TESTING APPARATUS AND METHOD FOR PHASE ADJUSTMENT CIRCUIT**
SELBSTPRÜFVORRICHTUNG UND VERFAHREN FÜR EINE PHASENEINSTELLSCHALTUNG
APPAREIL ET PROCÉDÉ DE TEST AUTOMATIQUE POUR CIRCUIT DE RÉGLAGE DE PHASE

(43) Date of publication of application: 08.02.2012
(73) Proprietor: Fujitsu Limited, Kawasaki-shi, Kanagawa 211-8588 (JP)
(72) Inventor: NAKAYAMA, Hiroshi, Kawasaki-shi Kanagawa 211-8588 (JP); ICHIMIYA, Junji, Kawasaki-shi Kanagawa 211-8588 (JP); ITOU, Daisuke, Kawasaki-shi Kanagawa 211-8588 (JP); ITOZAWA, Shintaro, Kawasaki-shi Kanagawa 211-8588 (JP)
(74) Representative: Ward, James Norman
(86) International application number: PCT/JP2009/001506
(87) International publication number: WO 2010/113213

(56) References cited:
- JP-A- 7 283 819
- JP-A- 2002 071 735
- JP-A- 2008 182 483
- US-A1- 2004 062 121
- US-A1- 2008 234 961

## Description

### Field

The embodiment discussed herein relates to a self-testing apparatus and a method for phase adjustment circuit.

### Background

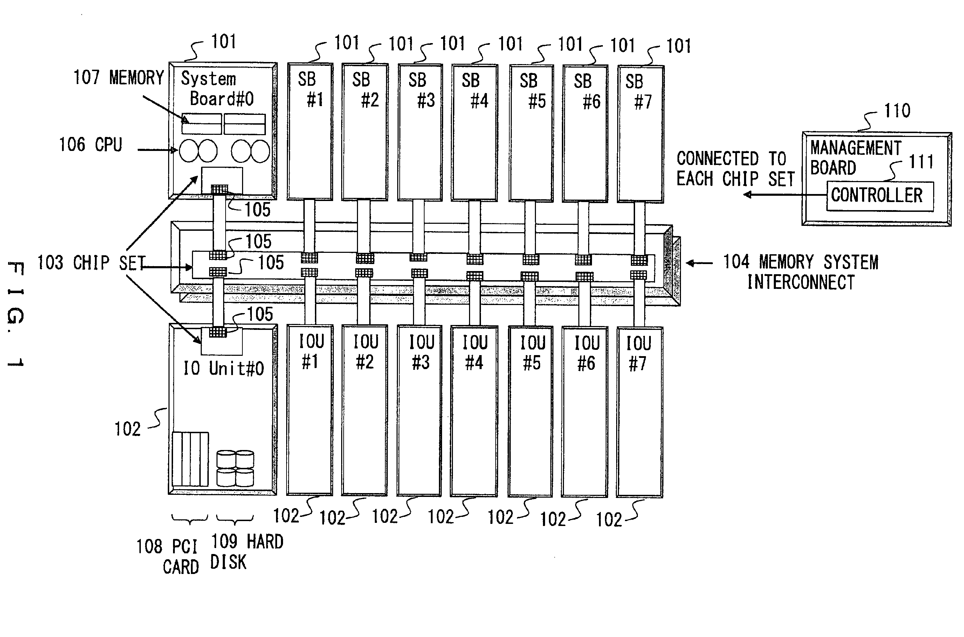

FIG. 1 is an example of a configuration of a common computer system including system boards (SB) 101 (#0 ∼ #7), I/O units (IOU) 102 (#0 - #7), a memory system interconnect 104, and a management board 110. The system board 101 is loaded with CPU (Central Processing Unit) 106 and memory 107. The I/O unit 102 is loaded with input/output devices such as a PCI card 108, a hard disk 109, etc. The memory system interconnect 104 interconnects the system board 101 with the I/O unit 102. The management board 110 is loaded with a controller 111 for controlling the system.

The system board 101, the I/O unit 102,and the memory system interconnect 104 are loaded with a controlling LSI called a chip set 103. LSIS are interconnected for communicating data. Therefore, the chip set 103 is loaded with a transmission/reception circuit 105.

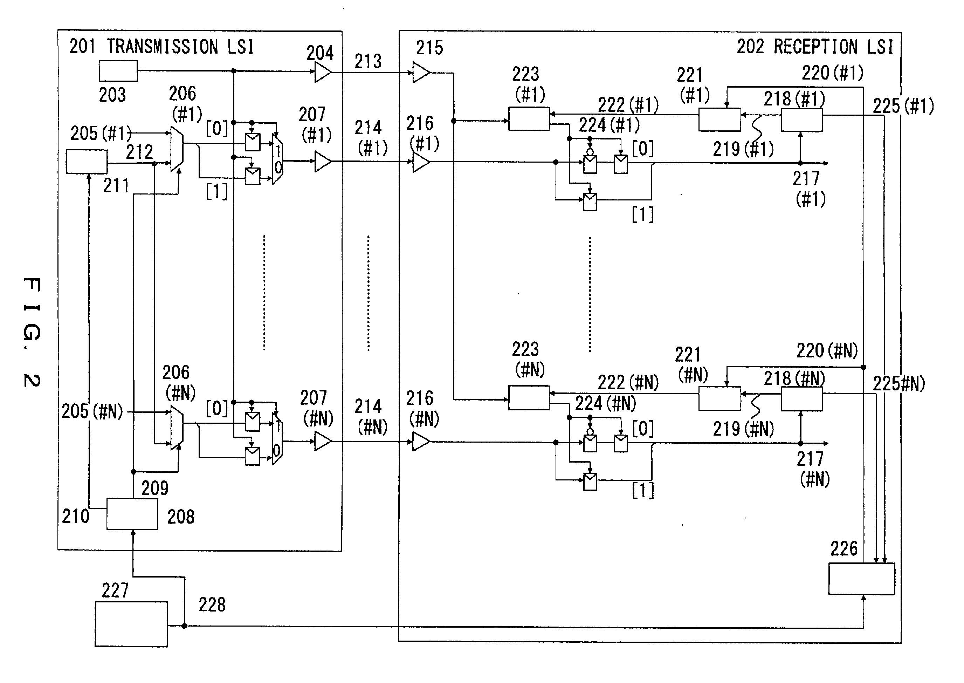

FIG. 2 is an example of a conventional connection configuration between, for example, a transmission unit of a first transmission/reception circuit 105 in the chip set 103 on the system board 101 and a reception unit of a second transmission/reception circuit 105 in the chip set 103 on the memory system interconnect 104 (hereafter the chip set 103 for the transmission unit of the transmission/reception circuit 105 is referred to as a transmission LSI 201, and the chip set 103 for the reception unit is referred to as a reception LSI 202). The transmission LSI 201 is connected to the reception LSI 202 through a clock line 213 and data lines 214 (#1 - #N).

The transmission LSI 201 includes a phase locked loop circuit (PLL) 203, a clock output circuit 204, data output circuits 207 (#1 ∼ #N), data selection circuits 206 (#1 ∼ #N), a pattern generation circuit 211, and a transmission unit control circuit 208.

Each of the data selection circuits 206 (#1 ∼ #N) selects transmission data 205 (#1 - #N) or a training pattern 212 according to a data selection signal 209.

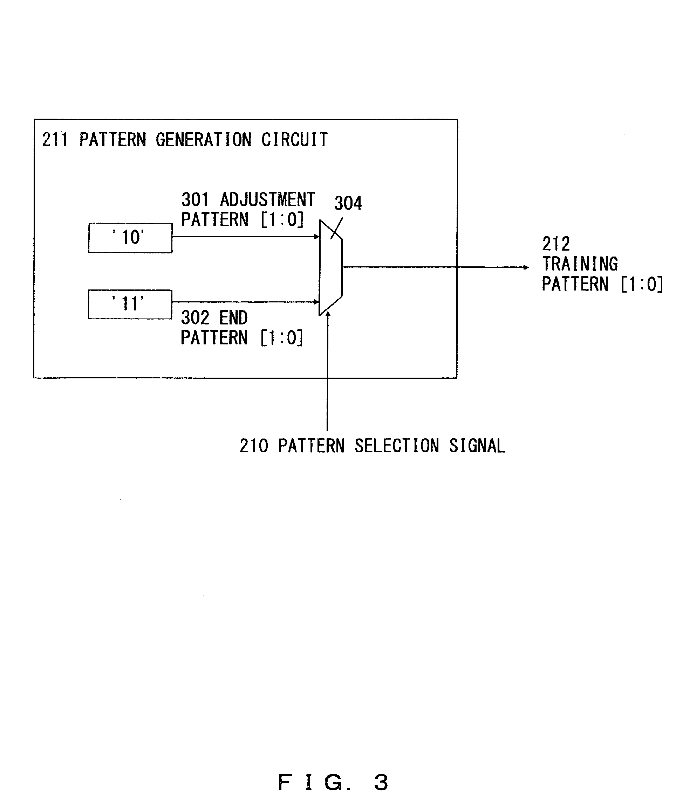

As illustrated in FIG. 3, the pattern generation circuit 211 in FIG. 2 selects the training pattern 212 according to a pattern selection signal 210. In this example, '10' is used as an adjustment pattern 301, and '11' is used as an end pattern 302. The training pattern 212 is used to adjust the clock (hereafter referred to as phase adjustment) at the center of the data waveform window during training using a data sequence specified between the transmission LSI 201 and the reception LSI 202.

The transmission unit control circuit 208 in FIG. 2 controls the data selection circuit 206 and the pattern generation circuit 211. When the initialization is required for the power-up, reset, etc. of the system, the transmission unit control circuit 208 starts training at a training start instruction 228 from an external controller 227. In addition, during the operation of the system, the transmission unit control circuit 208 periodically performs training using a built-in timer.

The reception LSI 202 in FIG. 2 includes a clock input circuit 215, data input circuits 216 (#1 ∼ #N), clock adjustment circuits 223 (#1 - #N), clock adjustment control circuits 221 (#1 - #N), pattern detection circuits 218 (#1 - #N), and a reception unit control circuit 226.

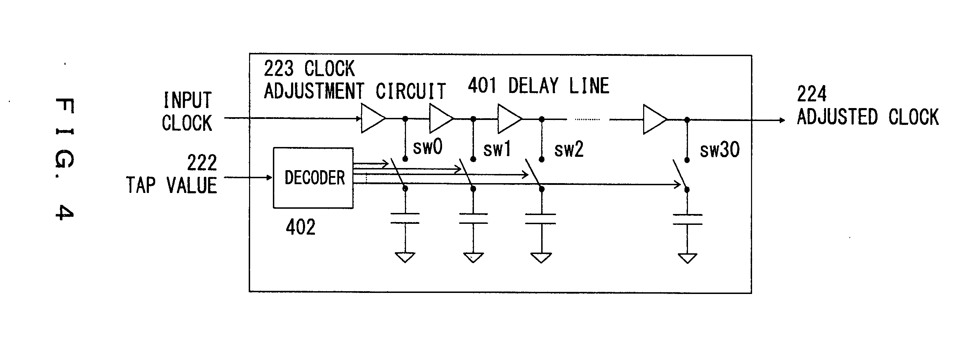

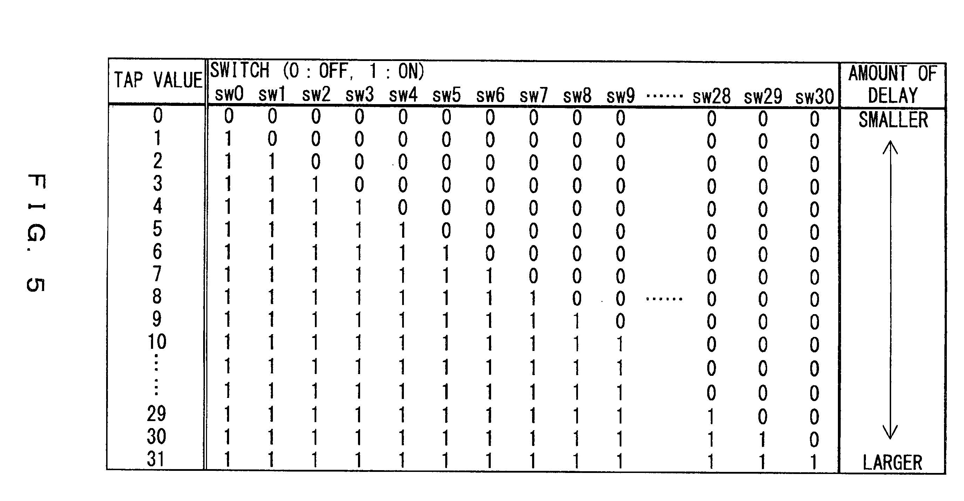

As illustrated in FIG. 4, the clock adjustment circuit 223 in FIG. 2 is configured by a delay line 401 and a decoder 402. In this circuit, the amount of delay of the delay line 401 is controlled by changing the load capacity depending on a phase adjustment setting value (hereafter referred to as a TAP value) 222 from the clock adjustment control circuit 221, thereby changing the phase of the input clock. In this example, as illustrated in FIG. 5, switches SWO through SW30 are controlled to be turned on and off according to the TAP value 222, thereby setting the amount of delay in 32 levels.

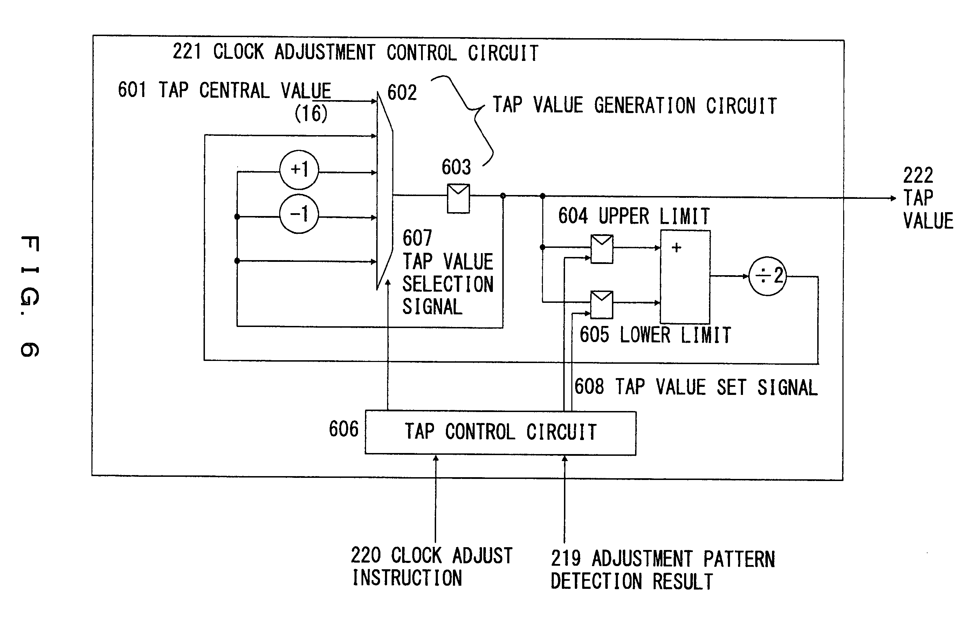

As illustrated in FIG. 6, the clock adjustment control circuits 221 (#1 ∼ #N) in FIG. 2 includes a TAP control circuit 606, a TAP value generation circuit configured by a selector 602 and a latch 603, a upper limit register 604, a lower limit register 605, etc. The phase adjusting operation is started at a signal of a clock adjust instruction 220 from the reception unit control circuit 226 in FIG. 2, and the TAP value 222 at the center of the data waveform window is calculated from an adjustment pattern detection result 219 from the pattern detection circuit 218 (FIG. 2) when the TAP value 222 is increased or decreased.

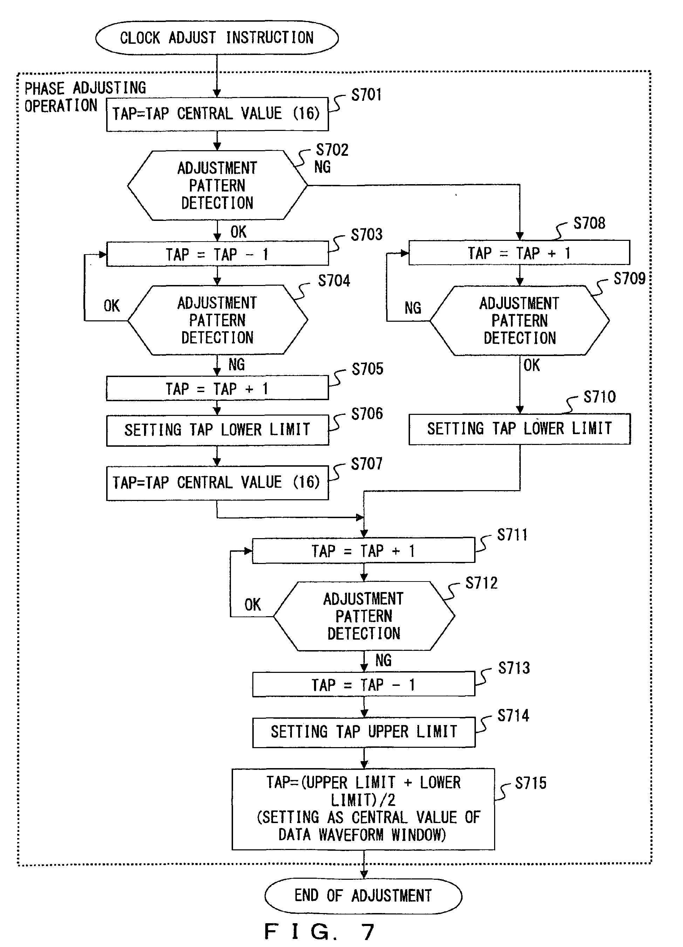

FIG. 7 is a flowchart of the phase adjusting operation performed by the TAP control circuit 606.

First, the TAP control circuit 606 allows the selector 602 to select a TAP central value 601 (16) according to the TAP value selection signal 607 (step S701). The TAP central value 601 is set in the latch 603, and is output as the TAP value 222.

Next, the TAP control circuit 606 determines an adjustment pattern detection result 219 from the pattern detection circuit 218 (FIG. 2) (step S702).

If the adjustment pattern detection result 219 refers to OK, the clock is currently located in the data waveform window in which the TAP lower limit is detected at the left end of the data waveform window. That is, while sequentially subtracting 1 from the TAP value 222 by a subtractor before the selector 602 (step S703), the TAP control circuit 606 sequentially sets the subtraction result in the latch 603 by allowing the selector 602 to select the result, thereby decreasing the TAP value 222. Then, the TAP control circuit 606 repeats the operation of determining the adjustment pattern detection result 219 until the result indicates NG (repeating steps S703 → S704 → S703 ...).

When the adjustment pattern detection result 219 refers to NG, the TAP control circuit 606 adds 1 to the TAP value 222 by the adder before the selector 602 (step S705), allows the selector 602 to select the result, and sequentially sets the result in the latch 603.

Then, the TAP control circuit 606 sets in the lower limit register 605 the TAP value 222 set in the latch 603 as the TAP lower limit according to a TAP value set signal 608 (step S706).

Then, the TAP control circuit 606 allows the selector 602 to select the TAP central value 601 according to the TAP value selection signal 607 (step S707). The TAP central value 601 is set in the latch 603 and output as the TAP value 222.

On the other hand, if the adjustment pattern detection result 219 indicates NG in the determination in step S702, the clock is currently located outside the data waveform window. Then, the TAP control circuit 606 increases the TAP value 222 by sequentially increasing by 1 by the adder before the selector 602 (step S708), and allowing the selector 602 to select the result and sequentially setting the result in the latch 603. The TAP control circuit 606 repeats the operation of determining the adjustment pattern detection result 219 until the result indicates OK (repeating steps S708 → S709 → S708).

When the adjustment pattern detection result 219 indicates OK, the TAP control circuit 606 sets the TAP value 222 set in the latch 603 as the TAP lower limit in the lower limit register 605 (step S710).

Then, after step S707 or S710, the TAP upper limit at the right end of the data waveform window is searched. That is, the TAP control circuit 606 increases the TAP value 222 by sequentially increasing by 1 by the adder before the selector 602 (step S711), and allowing the selector 602 to select the result and sequentially setting the result in the latch 603. The TAP control circuit 606 repeats the operation of determining the adjustment pattern detection result 219 until the result indicates NG (repeating steps S711 → S712 → S711).

When the adjustment pattern detection result 219 indicates NG, the TAP control circuit 606 subtracts 1 from the TAP value 222 by the subtractor before the selector 602 (step S713), allows the selector 602 to select the result, and sequentially sets the result in the latch 603.

Then, the TAP control circuit 606 sets the TAP value 222 set in the latch 603 as the TAP upper limit in the upper limit register 604 according to the TAP value set signal 608 (step S714).

After the TAP upper limit is obtained in the upper limit register 604 and the TAP lower limit is obtained in the lower limit register 605 as described above, the average value of the TAP upper limit and the TAP lower limit is calculated, and the result is selected by the selector 602 and set in the latch 603. As a result, the TAP value 222 is set as the central value of the data waveform window (step S715), thereby terminating the phase adjusting operation by the TAP control circuit 606.

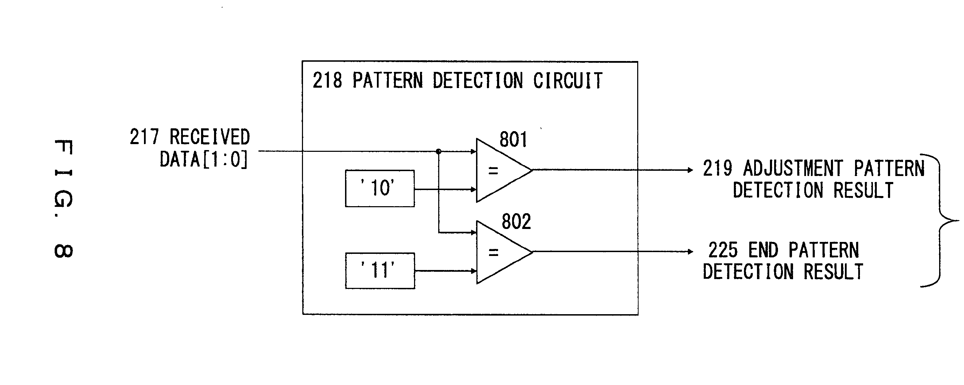

As illustrated in FIG. 8, the pattern detection circuits 218 (#1 - #N) in FIG. 2 are configured by comparators 801 and 802. In this example, when the data '10' is received as received data 217 (FIG. 2), the adjustment pattern detection result 219 is reported, and when the data '11' is received, an end pattern detection result 225 is reported.

The reception unit control circuit 226 in FIG. 2 outputs the clock adjust instruction 220 to the clock adjustment control circuit 221 (FIG. 6). If initialization is required when the system is powered up, reset, etc., then the reception unit control circuit 226 starts training at an instruction of the external controller 227. During the operation of the system, the reception unit control circuit 226 periodically performs the training using a built-in timer. In this case, the reception unit control circuit 226 outputs the clock adjust instruction 220 in the period in which the pattern detection circuits 218 (#1 - #N) reports the end pattern detection result 225 (FIG. 8).

Described below is the phase adjusting operation in the conventional connection configuration example of the transmission LSI 201 and the reception LSI 202. In the data transmission between the transmission LSI 201 and the reception LSI 202, it is necessary that the clock is aligned at the center of the data waveform window to reserve a margin so that data can be input to the flip-flop of the data input circuits 216 (#1 - #N) of the reception LSI 202. The necessary phase adjustment of the clock is performed using the training pattern 212 determined in advance between the transmission LSI 201 and the reception LSI 202. To attain this, in the transmission LSI 201, the training pattern 212 output from the pattern generation circuit 211 is selected by the data selection circuits 206 (#1 ∼ #N) and output from the data output circuits 207 (#1 ∼ #N). In the reception LSI 202, the training pattern 212 is received as the received data 217 (#1 ∼ #N) using the adjusted clocks 224 (#1 - #N) from the clock adjustment circuits 223 (#1 - #N) while changing the TAP values 222 (#1 - #N) by the clock adjustment control circuits 221 (#1 - #N). Then, based on the adjustment pattern detection results 219 (#1 ∼ #N) from the pattern detection circuits 218 (#1 - #N), the TAP control circuit 606 (FIG. 6) in the clock adjustment control circuits 221 (#1 ∼ #N) calculates the TAP values 222 (#1 ∼ #N) located at the center of the data waveform window according to the operation flowchart in FIG. 7.

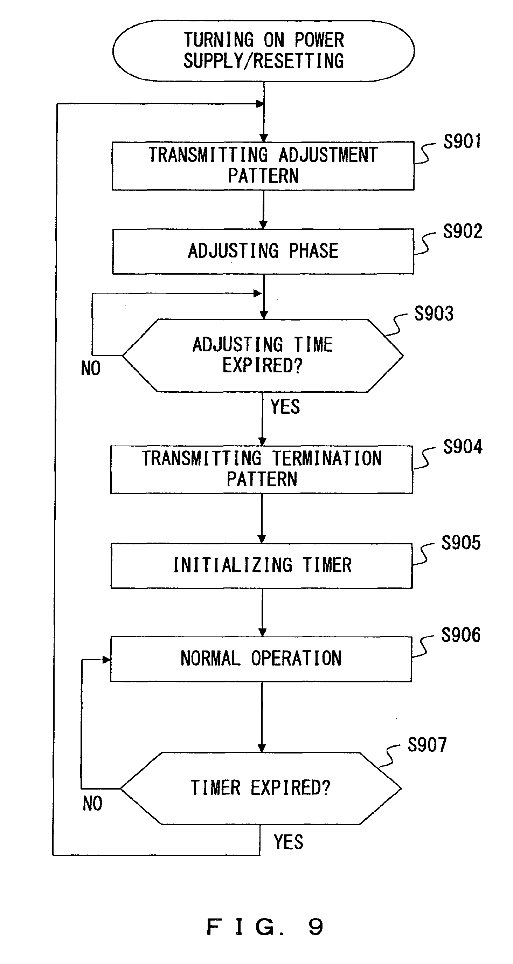

FIG. 9 is a flowchart of the operation of the entire control of the phase adjusting operation performed by the external controller 227, the transmission LSI 201, and the reception LSI 202 (FIG. 2).

First, the controller 227 outputs the training start instruction 228 to the transmission unit control circuit 208 in the transmission LSI 201 and the reception unit control circuit 226 in the reception LSI 202. As a result, the transmission unit control circuit 208 outputs the pattern selection signal 210 to the pattern generation circuit 211. As a result, the pattern generation circuit 211 having the configuration in FIG. 3 outputs the adjustment pattern 301 as the training pattern 212. The adjustment pattern 301 is selected by the data selection circuits 206 (#1 - #N) according to the data selection signal 209 from the transmission unit control circuit 208, and transmitted (step S901).

In the reception LSI 202, after the reception unit control circuit 226 receives the training start instruction 228 from the controller 227, it outputs the clock adjust instruction 220 from the reception unit control circuit 226 to the clock adjustment control circuits 221 (#1 - #N). As a result, the phase adjusting operation of the clock is performed by the phase adjusting operation (FIG. 7) by the clock adjustment control circuits 221 (#1 - #N).

In the transmission LSI 201, the transmission unit control circuit 208 waits until a specified adjustment time passes (step S903), and when the adjustment time passes and the determination result in step S903 is YES, the pattern selection signal 210 indicating the termination of the adjustment is output. As a result, the pattern generation circuit 211 having the configuration in FIG. 3 outputs the end pattern 302 as the training pattern 212. The end pattern 302 is selected by the data selection circuits 206 (#1 - #N) according to the data selection signal 209 from the transmission unit control circuit 208, and transmitted (step S904). When the transmission unit control circuit 208 transmits the end pattern 302, it initializes the timer not illustrated in the attached drawings but provided in the transmission unit control circuit 208 (step S905).

In the reception LSI 202, the end pattern 302 is detected by the pattern detection circuits 218 (#1 - #N), and the end pattern detection result 225 is reported to the reception unit control circuit 226, thereby terminating the clock adjust instruction 220 from the reception unit control circuit 226 to the clock adjustment control circuits 221 (#1 ∼ #N). When the end pattern detection result 225 is reported from any of the pattern detection circuits 218 (#1 - #N), the reception unit control circuit 226 initializes the timer in the reception unit control circuit 226 but not illustrated in the attached drawings (step S905).

Then, until the timer expires, the normal operation of the data transmission is performed (repetition of step S906 → S907 → S906).

When the timer expires and the determination in step S907 is YES, control is returned to step S901, and the output of the adjustment pattern 301 is performed again and the phase adjusting process is performed. As a result, the phase adjusting process is periodically performed.

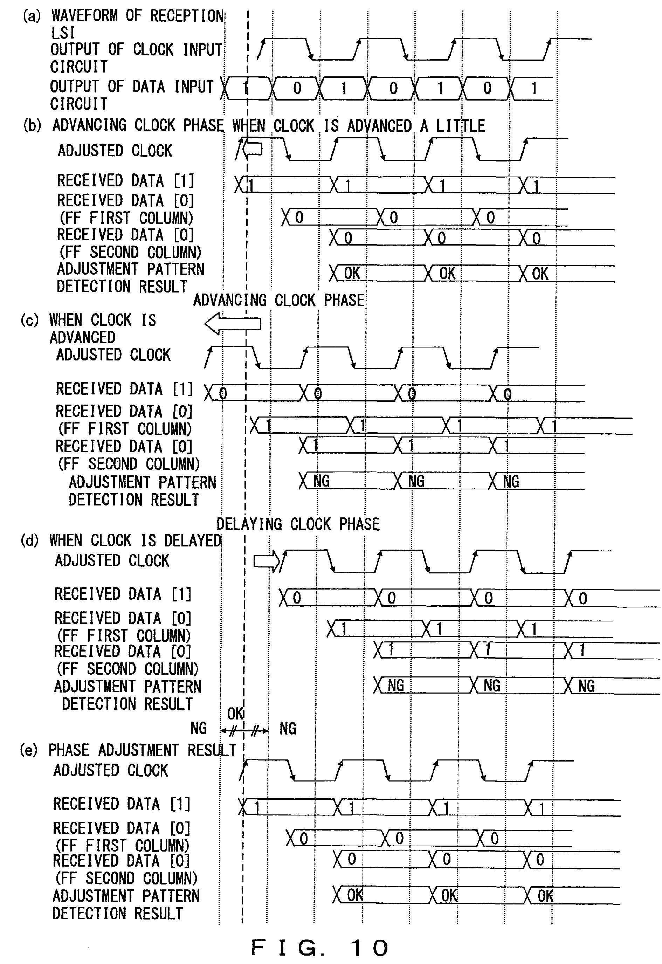

FIG. 10 is a timing chart of the operation of an example of the operation timing of the conventional phase adjusting operation.

During the training, the pattern generation circuit 211 selects the adjustment pattern 301 (see FIG. 3). As a result, the repetitive pattern of 010101 ... is transmitted and received.

The part (a) in FIG. 10 illustrates the waveforms of the clock input circuit 215 and the data input circuits 216 (#1 ∼ #N) of the reception LSI 202. At the up edge of the clock, the data '1' is received, and at the down edge, the data '0' is received. Thus, the received data [1:0] of '10' is an expected value.

The part (b) in FIG. 10 illustrates the case in which the clock adjustment circuit 223 advances the clock input a little. At the up edge of the clock, the data '1' is received, and at the down edge, the data '0' is received, thereby matching the expectation value. As a result, the adjustment pattern detection result 219 output by the pattern detection circuit 218 is OK.

The part (c) in FIG. 10 illustrates the case in which the clock input is further advanced by the clock adjustment circuit 223. The up edge of the clock precedes the data '1', and the data '0' is received. Similarly, the data of '1' is received at the down edge which does not match the expectation value. As a result, the adjustment pattern detection result 219 output by the pattern detection circuit 218 is NG.

The part (d) in FIG. 10 illustrates the case in which the clock adjustment circuit 223 delays the clock input. The up edge of the clock follows the data of '1', and receives the data of '0'. Similarly, the data of '1' is received at the down edge which does not match the expectation value. As a result, the adjustment pattern detection result 219 output by the pattern detection circuit 218 is NG.

The part (e) in FIG. 10 illustrates a phase adjustment result. As illustrated in (a) through (d) in FIG. 10, the received data 217 is compared with the expectation value while the clock adjustment circuit 223 changes the phase of the clock by a change of the TAP value 222 by the phase adjusting operation in the clock adjustment control circuit 221. Accordingly, a matching result (OK) and a non-matching result (NG) are determined on each phase. Based on the result, the TAP value 222 at the center of the data waveform window is calculated by the phase adjusting operation in the clock adjustment control circuit 221.

As described above, the conventional clock phase adjusting operation is automatically performed by the pattern generation circuit 211, the pattern detection circuits 218 (#1 ∼ #N), the clock adjustment control circuits 221 (#1 - #N), and the clock adjustment circuits 223 (#1 - #N), etc. in the LSI. The automatic adjusting function is a configuration indispensable for stably operating the transmission LSI 201 and the reception LSI 202. However, although there is a fault in the delay line 401 and its control circuit 402 etc. illustrated in FIG. 4 in, for example, the clock adjustment circuit 223, an operation can be optimally adjusted and performed without a problem.

In this case, although an operation is performed apparently without a problem, an operation error can occur all of a sudden when a condition such as a voltage, a temperature, a frequency, a clock/data line length, etc. changes. It is hard to detect such an error, and designate the cause of the error because of low reproducibility. Especially, in the incorporated state in a computer system as illustrated in FIG. 1, it is hard to detect the error.

As the conventional technology related to the present application, the following document of the prior art is disclosed
Patent Document 1: Japanese Laid-open Patent Publication No. 2001-67242
JP-A-2002 071735 discloses a signal-inspecting circuit which outputs the result of calculating an AND (or OR) of a signal to be measured, a signal having a phase difference of a jitter guarantee amount to the signal to be measured, and an inverted signal delayed by a guarantee period. The circuit judges the LSI as good when the output is always Low (or High).
US-A-2008/234961 discloses a test apparatus and measurement circuit for testing a device.
US-A-2004/062121 discloses a semiconductor memory device having a duty cycle correction circuit and an interpolation circuit interpolating a clock signal in the semiconductor memory device.

### Summary

The problem to be solved is to easily detect and analyze an error which is difficult to detect and reproduce with a simple configuration in a phase adjustment circuit.

A self-testing apparatus and a self-testing method according to the claimed invention are defined in the independent claims, to which reference should now be made.

The present invention is realized as a self-testing apparatus or method for a phase adjustment circuit which performs a phase adjustment on a clock by inputting an adjustment pattern signal to an electronic circuit and performing a phase adjusting operation of stepwise changing the phase adjustment set value for a change of the phase of the clock for the operation of an electronic circuit while detecting the adjustment pattern signal, and has the following configuration when it is realized as, for example, an apparatus.

A signal inversion unit inverts an adjustment pattern signal.

An adjustment result acquisition unit acquires a first phase adjustment set value adjusted and obtained when a phase adjusting operation is performed in a state in which the adjustment pattern signal is not inverted, a first detection frequency of the adjustment pattern signal in a runtime of the operation, a second phase adjustment set value adjusted and obtained when the phase adjusting operation is performed in a state in which the adjustment pattern signal is inverted by the signal inversion unit, and a second detection frequency of the adjustment pattern signal in the runtime of the operation.

A phase adjusting operation test unit tests an operating state of the phase adjusting operation based on the first and second phase adjustment set values and the first and second detection frequencies of the adjustment pattern obtained by the adjustment result acquisition unit.

An error of a clock adjustment circuit (phase adjustment circuit) in an LSI is hard to detect and the cause of the error is hard to designate because of low reproducibility. With the above-mentioned configuration, the detection and the analysis of an error can be easily performed. As a result, a problem can be fast detected and the time required to make a search for a problem can be considerably shortened. For example, a defective product can be removed in an LSI unit test by a tester during the production of an LSI. In addition, an error can be avoided by diagnosing the error prior to a practical operation when a system operation is performed. Furthermore, when an error occurs during the system operation, it can be immediately determined by performing a diagnosis again whether or not an error of a phase adjustment circuit has occurred.

### Brief Description of Drawings

FIG. 1 is an example of a configuration of a common computer system;
FIG. 2 is an example of a connection configuration between the transmission LSI 201 and the reception LSI 202;
FIG. 3 is an example of a configuration of a pattern generation circuit;
FIG. 4 is an example of a configuration of a clock adjustment circuit;
FIG. 5 is a data operation table of a clock adjustment circuit;
FIG. 6 is an example of a configuration of a conventional clock adjustment control circuit;
FIG. 7 is a flowchart of the operation of the clock adjusting process by a TAP control circuit;
FIG. 8 is an example of a configuration of a pattern detection circuit;
FIG. 9 is a flowchart of the operation of the entire control of the phase adjusting operation;
FIG. 10 is a timing chart of an operation of an operation timing example of a conventional clock adjusting process;

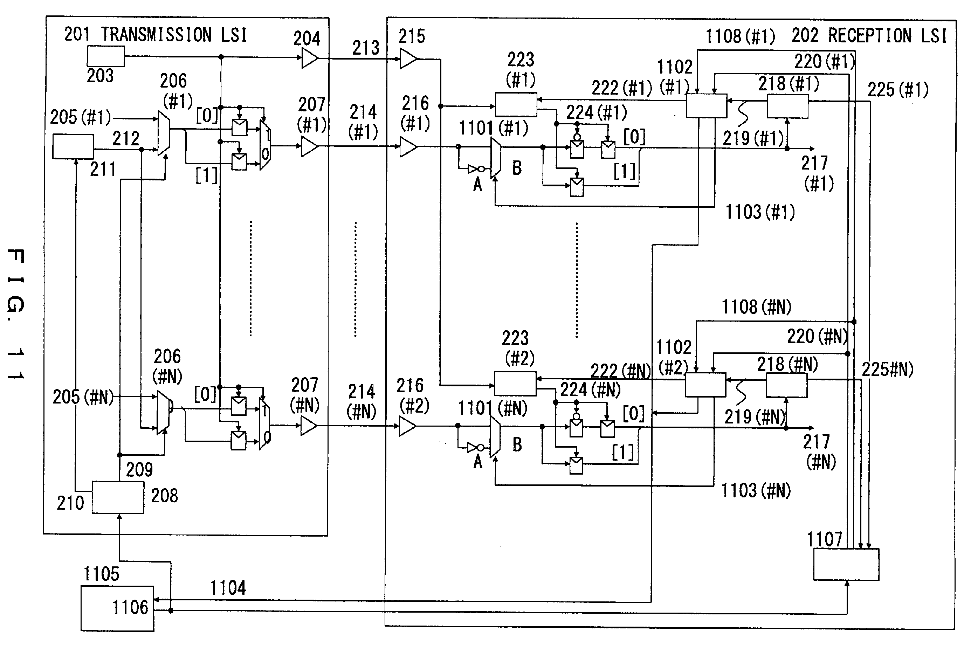

FIG. 11 illustrates an embodiment of a configuration of connecting a transmission LSI and a reception LSI;

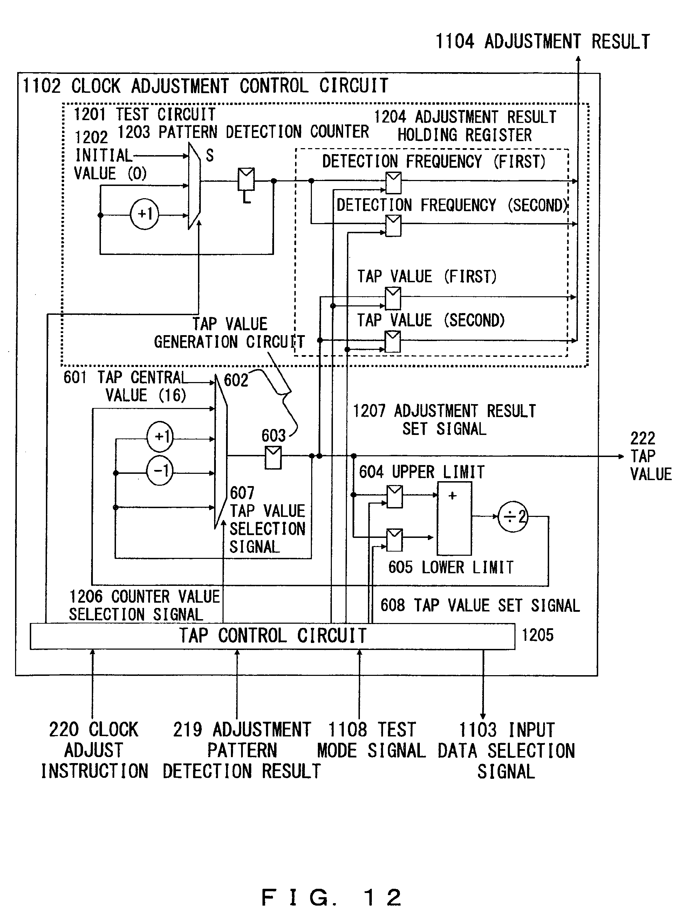

FIG. 12 is a configuration of a circuit of the clock adjustment control circuit according to an embodiment of the present invention;

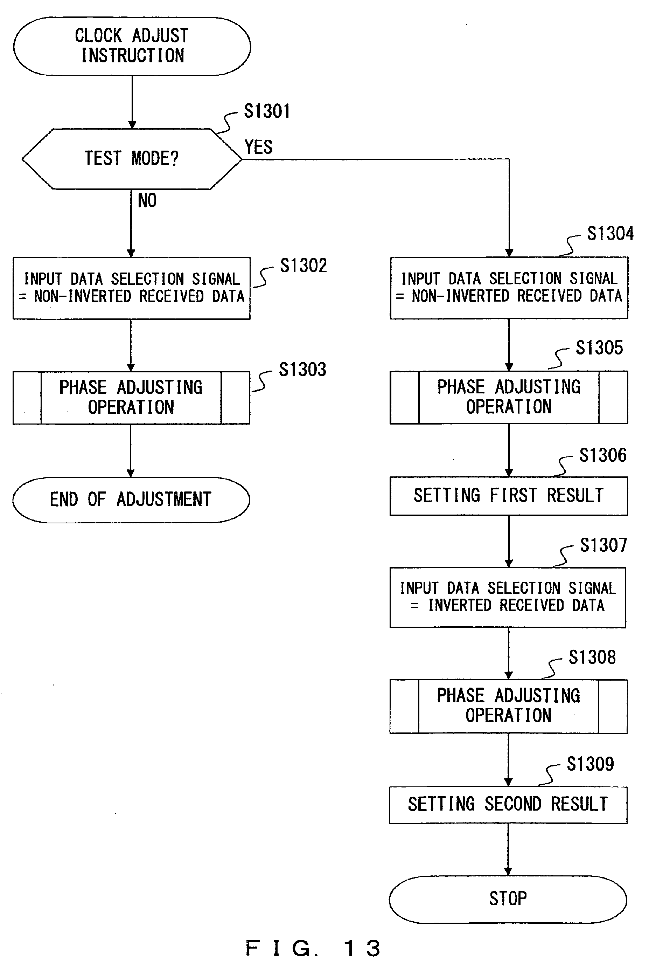

FIG. 13 is a flowchart of an operation of controlling the TAP control circuit according to an embodiment of the present invention;

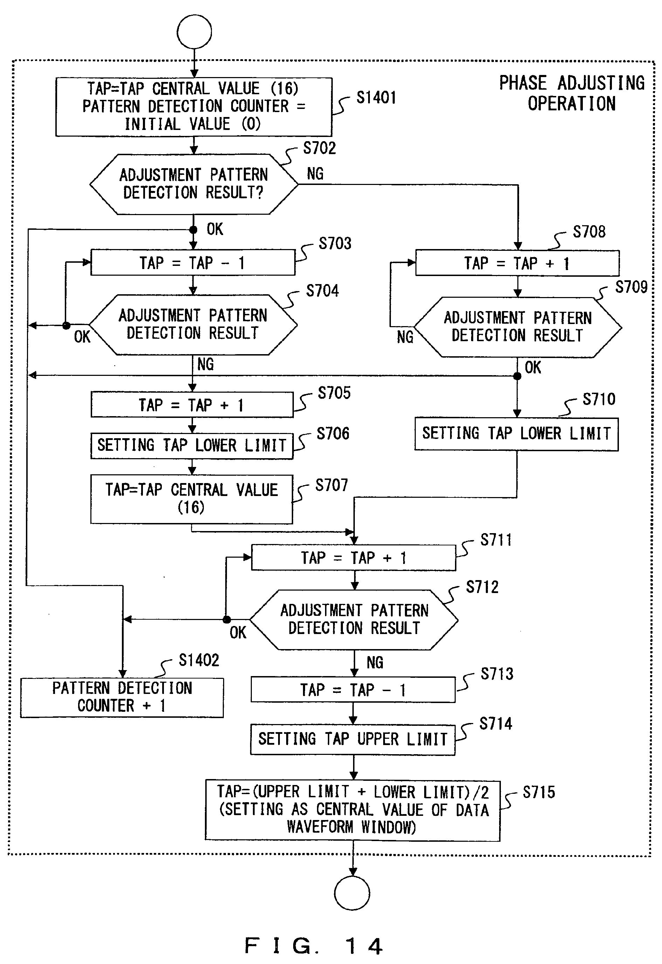

FIG. 14 is a flowchart of a phase adjusting operation according to an embodiment of the present invention;

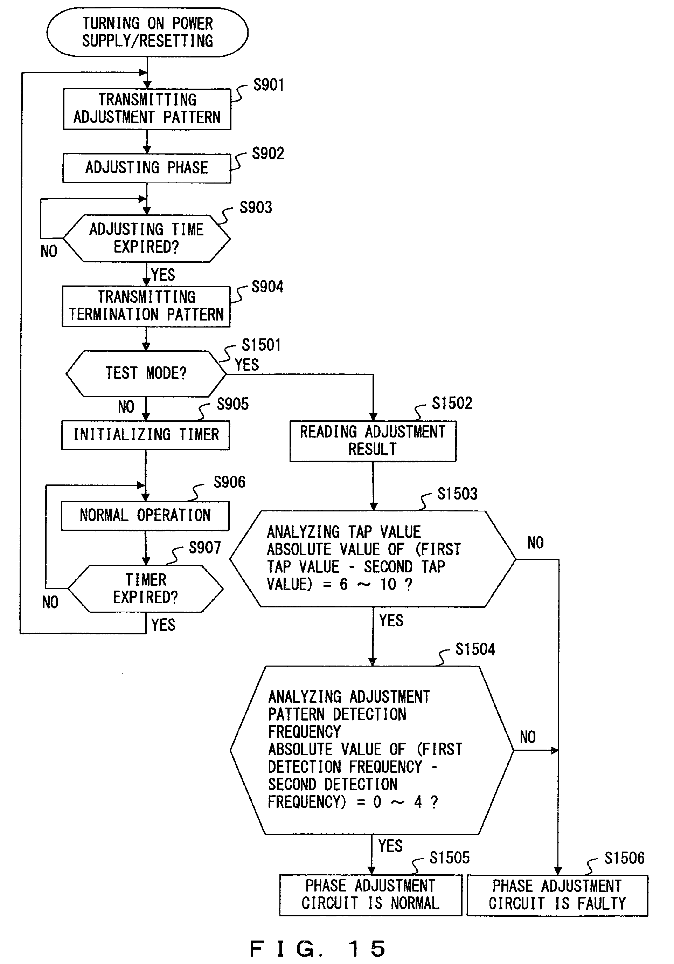

FIG. 15 is a flowchart of an operation of the entire control of the phase adjusting operation according to an embodiment of the present invention;

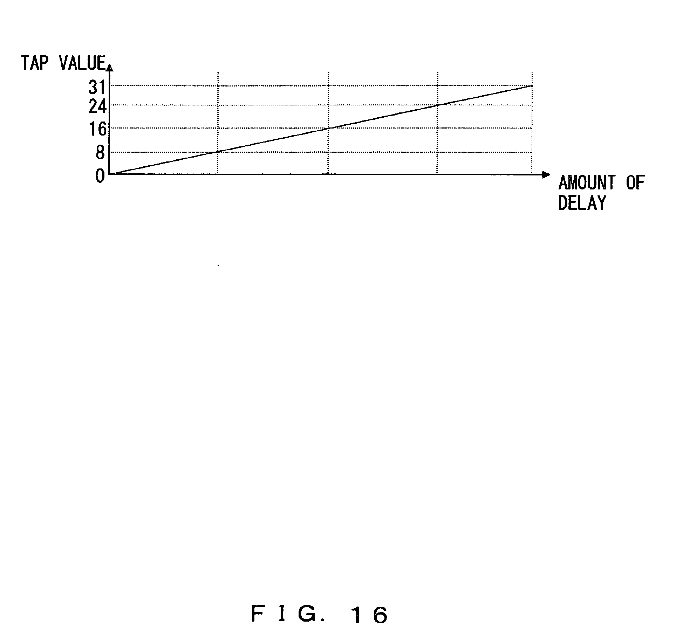

FIG. 16 is an example (normal operation) of a characteristic of the phase adjustment circuit according to an embodiment of the present invention;

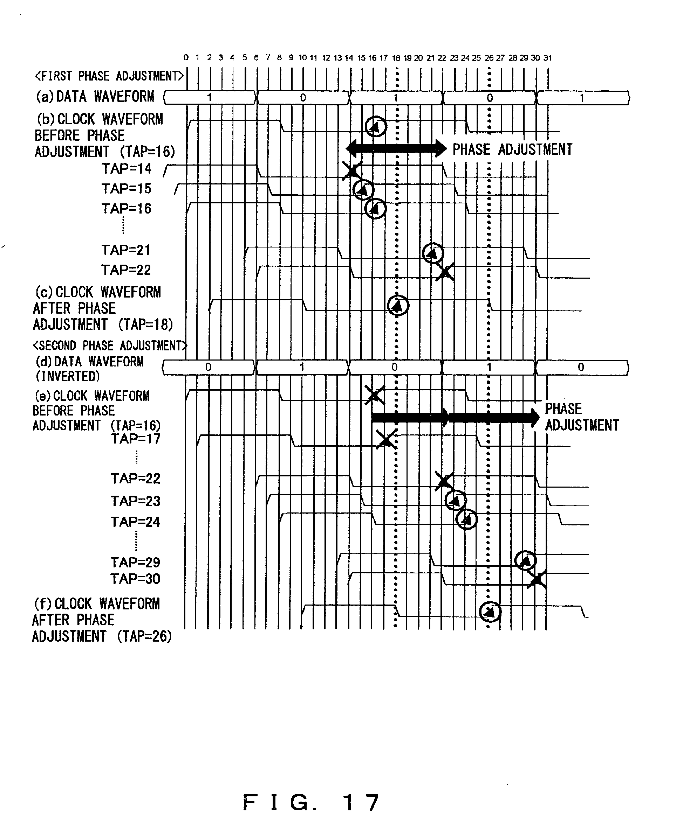

FIG. 17 is an example (normal operation) of a timing chart of the phase adjustment circuit according to an embodiment of the present invention;

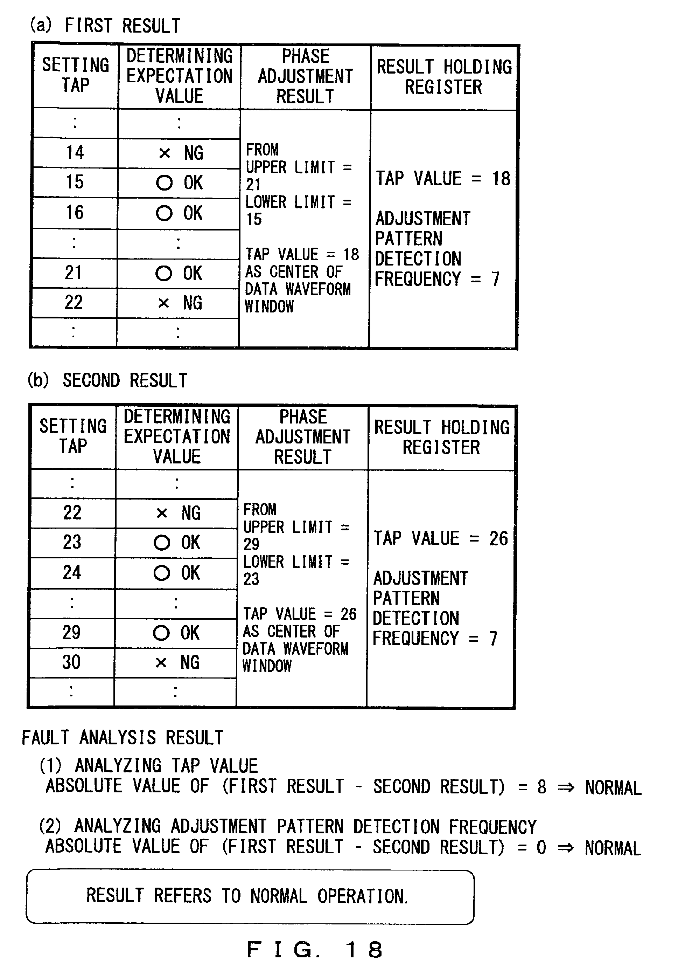

FIG. 18 is an example (normal operation) of a phase adjustment result of the phase adjustment circuit according to an embodiment of the present invention;

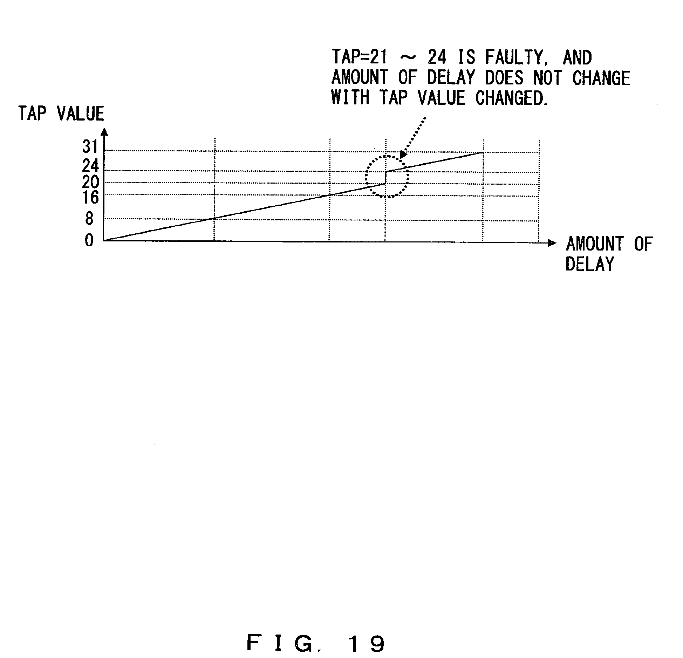

FIG. 19 is an example (abnormal operation) of a characteristic of the phase adjustment circuit according to an embodiment of the present invention;

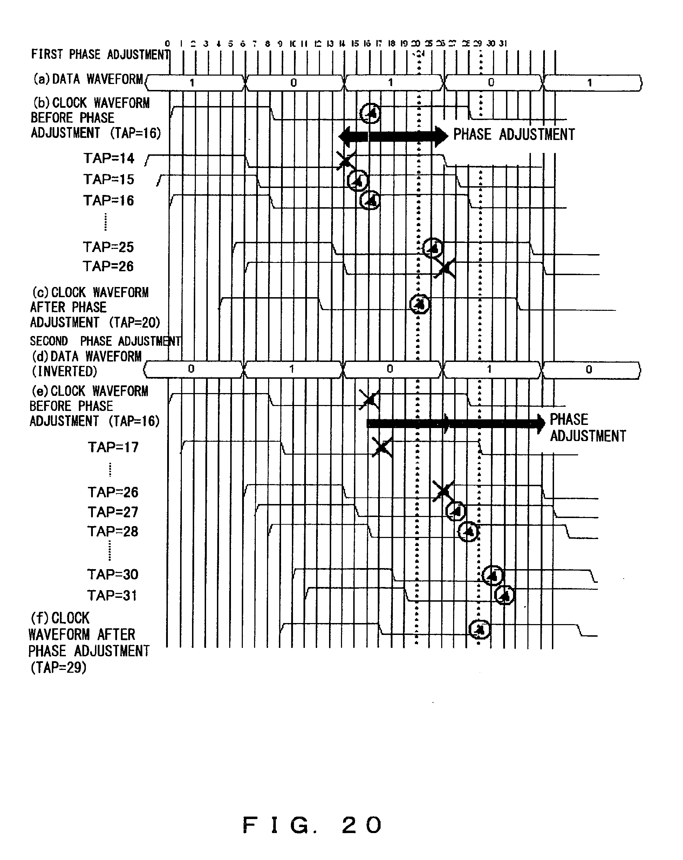

FIG. 20 is an example (abnormal operation) of a timing chart of the phase adjustment circuit according to an embodiment of the present invention;

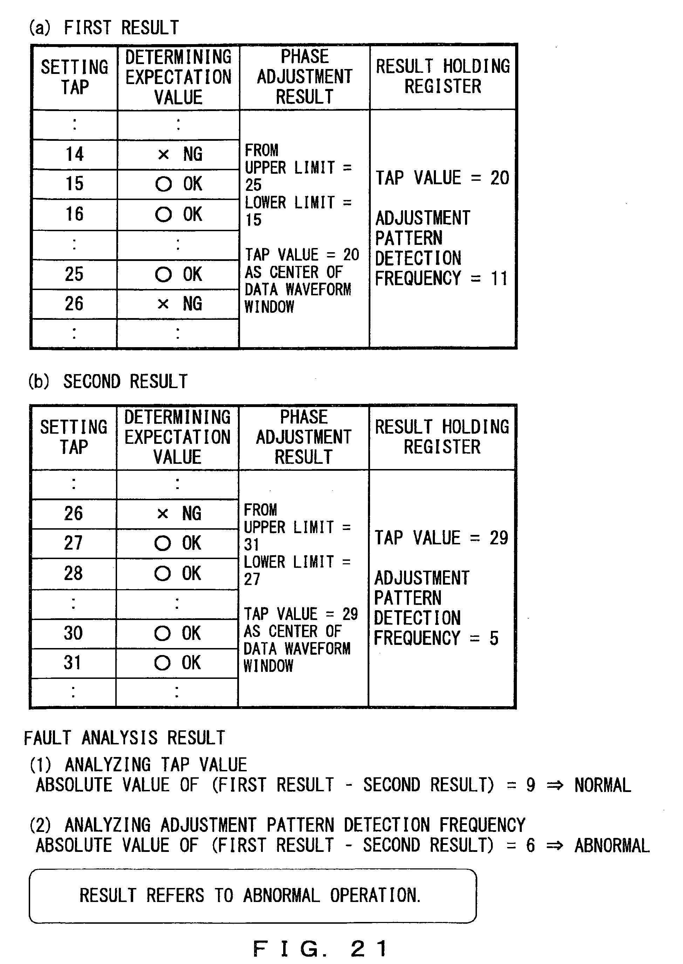

FIG. 21 is an example (abnormal operation) of a phase adjustment result of the phase adjustment circuit according to an embodiment of the present invention; and

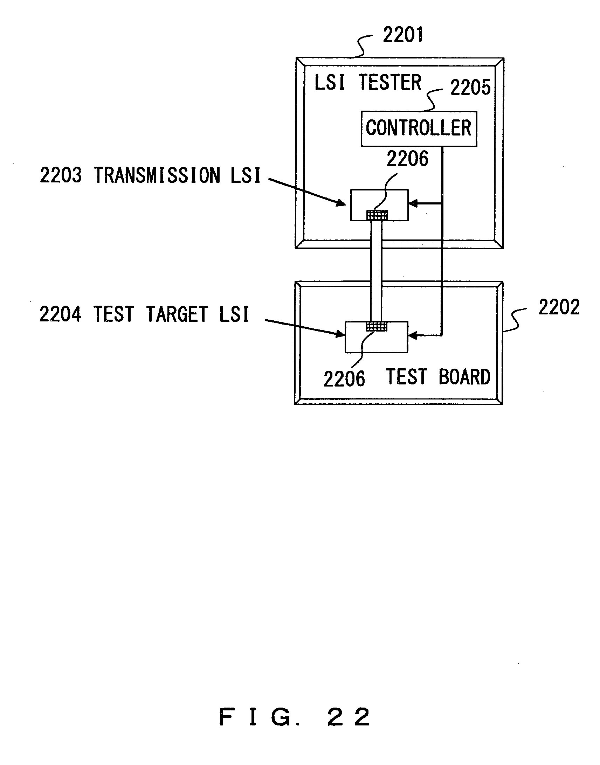

FIG. 22 is a configuration of an embodiment of an LSI unit test.

### Description of Embodiments

The embodiment is described below in detail with reference to the attached drawings.

FIG. 11 illustrates an embodiment of a configuration of connecting a transmission LSI and a reception LSI.

The system to which the configuration is applied is a part of the transmission/reception circuit 105 in the chip set 103 in the computer system illustrated in FIG. 1 as with the conventional technology.

In FIG. 11, the component having the same function as the conventional technology illustrated in FIG. 2 is assigned the same reference numeral.

The following processing units are added to the reception LSI 202 in the embodiment in FIG. 11 in addition to the connection configuration illustrated in FIG. 2.

First, inversion circuits 1101 (#1 - #N) (signal inversion units) for inverting the received data 217 (#1 - #N) are added to the reception LSI 202. The inversion circuits 1101 (#1 - #N) can be realized by a simple circuit configuration with an inverter A and a selector B as illustrated in FIG. 11. The selector B selects any data obtained by inverting by the inverter A the non-inverted received data 217 (#1 - #N) and data 217 (#1 - #N) and outputs the result to the subsequent stage in the phase adjusting operation by clock adjustment control circuits 1102 (#1 ∼ #N). The selector B operates based on input data selection signals 1103 (#1 - #N) from the clock adjustment control circuits 1102 (#1 - #N).

Next, in the reception LSI 202, the clock adjustment control circuits 1102 (#1 ∼ #N) have a configuration different from the configuration of the clock adjustment control circuits 221 (#1 - #N) in FIG. 2. An external controller 1105 and a reception unit control circuit 1107 have a function obtained by expanding the functions of the controller 227 and the reception unit control circuit 226 in FIG. 2.

The present embodiment is characterized by a BIST (built-in self-test) function for the clock adjustment circuits 223 (#1 - #N).

FIG. 12 is a configuration of a circuit of the clock adjustment control circuit 1102 in FIG. 11 according to an embodiment of the present invention.

In FIG. 12, the circuit portion for performing the same process as the conventional clock adjustment control circuit 221 illustrated in FIG. 6 is assigned the same reference numeral.

With the configuration in FIG. 12, a test circuit 1201 (adjustment result acquisition unit) is added in addition to the conventional configuration, and a new TAP control circuit 1205 performs the entire control.

The test circuit 1201 has a adjustment result holding register 1204 for holding a result of a phase adjusting operation. The contents of the adjustment result holding register 1204 can be read by the external controller 1105 (see FIG. 11) as an adjustment result 1104.

In addition, the test circuit 1201 has a pattern detection counter 1203. The circuit is configured by a selector S and a latch L. Their functions are described later.

FIG. 13 is a flowchart of an operation of controlling the TAP control circuit 1205.

First, the TAP control circuit 1205 determines based on a test mode signal 1108 input from the reception unit control circuit 1107 whether or not the current mode is a test mode (step S1301). A test mode refers to a mode in which the clock adjustment circuits 223 (#1 ∼ #N) in FIG. 11 are checked whether or not they are normally operating. The setting of the test mode is performed in the reception unit control circuit 1107 according to a control signal 1106 from the external controller 227. Based on the setting, the test mode signals 1108 (#1 ∼ #N) are supplied from the reception unit control circuit 1107 to the clock adjustment control circuits 221 (#1 - #N).

If the current mode is not the test mode, and the determination in step S1301 is NO, then the TAP control circuit 1205 outputs to the selector B of the inversion circuit 1101 in FIG. 11 the input data selection signal 1103 for selecting of the non-inverted received data 217 (step S1302)

Next, the TAP control circuit 1205 performs the phase adjusting operation (step S1303).

FIG. 14 is a flowchart of the phase adjusting operation in step S1303. In the flowchart of the operation, the sequence of the processes in steps S702 through S715 is the same as the sequence of the processes in steps S702 through S715 illustrated in FIG. 7. The process in step S702 is included in the process in step S1401.

By the sequence of the processes and the configurations of 601 through 605, 606, 607, and 608, the same phase adjusting operation as in the conventional technology is performed in a system operation mode. That is, the TAP upper limit and the TAP lower limit are calculated while sequentially changing the TAP value 222, and the TAP upper limit and the TAP lower limit are respectively set in the upper limit register 604 and the lower limit register 605. Afterwards, the average value of the TAP upper limit and the TAP lower limit is calculated, and the result is selected by the selector 602 and set in the latch 603. As a result, the TAP value 222 is set at the central value of the data waveform window. The explanation of the operation is omitted here because it is described above with reference to FIG. 7.

If the current mode is the test mode and the determination in step S1301 is YES, the TAP control circuit 1205 outputs to the selector B of the inversion circuit 1101 in FIG. 11 the input data selection signal 1103 for selection of the non-inverted received data 217 (step S1304). Then, the TAP control circuit 1205 performs the phase adjusting operation in the operation flowchart in FIG. 14 (step S1305), and the first execution result is held in the internal adjustment result holding register 1204 (FIG. 12) (step S1306).

Then, the TAP control circuit 1205 outputs to the selector B of the inversion circuit 1101 in FIG. 11 the input data selection signal 1103 for selection of the received data obtained by inverting the received data 217 by the inverter A (step S1307). The TAP control circuit 1205 then performs the phase adjusting operation according to the operation flowchart in FIG. 14 (step S1308), and holds the second execution result in the internal adjustment result holding register 1204 (step S1309).

In the phase adjusting operation in step S1305 or S1308, the TAP control circuit 1205 first allows the selector S of the pattern detection counter 1203 to select an initial value 1202 (0) according to a counter value selection signal 1206. As a result, the initial value of 0 is set in the latch L of the pattern detection counter 1203.

Next, the TAP control circuit 1205 functions as follows when it determines that the adjustment pattern detection result 219 from the pattern detection circuit 218 (FIG. 11) indicates OK in step S704, S709, or S712 as a result of the change of the TAP value 222. That is, the TAP control circuit 1205 allows the selector S of the pattern detection counter 1203 to select according to the counter value selection signal 1206 the value obtained by the adder before the selector S adding 1 to the pattern detection counter value set in the latch L. As a result, the pattern detection counter value obtained by adding 1 to the precedent counter value is set in the latch L of the pattern detection counter 1203. That is, the pattern detection counter 1203 counts as the pattern detection counter value the adjustment pattern detection frequency based on a change of the TAP value 222 each time the TAP value 222 is changed and an adjustment pattern is detected.

In step S1306, the TAP control circuit 1205 sets the value of the latch L of the pattern detection counter 1203 sets according to an adjustment result set signal 1207 in FIG. 12 in the register for holding the detection frequency (first) in the adjustment result holding register 1204. The TAP control circuit 1205 also sets according to the adjustment result set signal 1207 the TAP value 222 obtained in the latch 603 of the TAP value generation circuit in the register for holding the TAP value (first) in the adjustment result holding register 1204. That is, the adjustment result holding register 1204 holds the adjustment pattern detection frequency based on the change of the TAP value 222 in the first phase adjusting operation performed without inverting the received data 217, and the finally adjusted TAP value 222.

Similarly, in step S1309, the TAP control circuit 1205 sets the value of the latch L of the pattern detection counter 1203 sets according to an adjustment result set signal 1207 in FIG. 12 in the register for holding the detection frequency (second) in the adjustment result holding register 1204. The TAP control circuit 1205 also sets according to the adjustment result set signal 1207 the TAP value 222 obtained in the latch 603 of the TAP value generation circuit in the register for holding the TAP value (second) in the adjustment result holding register 1204. That is, the adjustment result holding register 1204 holds the adjustment pattern detection frequency based on the change of the TAP value 222 in the second phase adjusting operation performed by inverting the received data 217, and the finally adjusted TAP value 222.

FIG. 15 is a flowchart of an operation of the entire control of the phase adjusting operation and the error analysis performed by the external controller 1105 (FIG. 11). In this case, the external controller 1105 functions as a phase adjusting operation test unit.

If it is determined that the current mode is not the test mode (but the system operation mode), then the determination in step S1501 in FIG. 15 is NO, thereby performing the sequence of the processes in steps S901 through S907 in FIG. 15. These processes are the same as the entire control of the phase adjusting operation performed by the conventional controller 227 in FIG. 2. That is, when the test mode is not entered (the system operation mode is entered), the normal phase adjusting operation as in the conventional technology is performed. The explanation of the operation is described above with reference to FIG. 9, and is omitted here.

When it is determined that the current mode is the test mode, the determination in step S1501 in FIG. 15 is YES, and the controller 1105 reads the adjustment pattern detection frequency based on the change of the TAP value 222 in the first and second phase adjusting operations and the finally adjusted TAP value 222 from the adjustment result holding register 1204 of the clock adjustment control circuits 1102 (#1 - #N) (step S1502).

The controller 1105 performs the error analysis in the following two steps using each value read in step S1502.

First, the controller 1105 performs the analysis of the TAP value (step 51503). That is, when the absolute value of the difference between the first TAP value result and the second TAP value result is 6 through 10, the controller 1105 determines that the clock adjustment circuits 223 (#1 - #N) normally operate. Since the polarity of the adjustment pattern 301 (FIG. 3) obtained as the received data 217 is inverted between the first and second results, it is preferable that the phase adjustment results are shifted from each other by half cycle. If the clock adjustment circuit 223 in the embodiment has an adjustment range of 16 taps in one cycle, it is preferable that the difference as a shift between the first and second is a half cycle corresponding to the 8th tap of the 16 taps. However, since there can be a variance of about ±1 tap in a phase adjustment result, it is determined that the difference in TAP value between the first and second results is normal if it ranges from 6 to 10 taps.

In the case above, if the absolute value of the difference between the first and second results does not range from 6 to 10 taps, then the controller 1105 determines that the clock adjustment circuit 223 does not normally function and refers to a fault (step S1506). As an example of the fault, the change in amount of delay of the delay line 401 (FIG. 4) in the clock adjustment circuit 223 with respect to the TAP value may not refer to a monotonous increase, but may largely change or may not change at all. In this case, since it is difficult to set a clock at the center of the data waveform window, there is the possibility that a transmission error occurs depending on the environmental conditions.

After the determination in step S1503, the controller 1105 analyzes the adjustment pattern detection frequency (step S1504). That is, when the absolute value of the difference between the first TAP value result and the second TAP value result is 0 through 4, the controller 1105 determines that the clock adjustment circuits 223 (#1 ∼ #N) normally operate. Since the polarity of the adjustment pattern 301 (see FIG. 3) obtained as the received data 217 is inverted between the first and second results, it is preferable that the phase adjustment results are shifted from each other by half a cycle. Since the width of the data waveform window is the same, the adjustment pattern detection frequency detected during the phase adjusting operation is the same between the first and second results. However, since there can be a variance of about 1 tap at both ends of the data waveform window in a phase adjustment result, it is determined that the difference in TAP value between the first and second results is normal if it ranges from 0 to 4 taps.

Thus, when it is determined that the operation is normally performed both in steps S1502 and S1503, the controller 1105 determines that the clock adjustment circuit 223 normally functions and the operation is normally performed (step S1505).

If the absolute value of the difference between the first and second results obtained in step S1504 does not range from 0 through 4 taps, the controller 1105 determines that the clock adjustment circuit 223 does not normally function and refers to a fault (step S1506). As an example of the fault, the change steps of the amount of delay of the delay line 401 (see FIG. 4) in the clock adjustment circuit 223 are not equal. In this case, a clock is set in the position shifted from the center of the data waveform window, and there is the possibility that a transmission error occurs depending on the environment conditions.

The values of the range used in determining the normality of an operation in steps S1503 and S1504 are only example, and not limited to the values. They are determined depending on various factors of variances (for example, production variance, voltage and temperature variance, variance of duty ratios of data waveform, clock waveform, etc.). The value of the range can be determined with allowance for protection against erroneous determination of a good product for a faulty product.

In the steps S1503 and S1504 above, it is preferable that both determinations are performed to improve the fault detection accuracy. However, since the fault can be detected by one of the determinations, only one of the determinations can be made.

An example of the case in which the phase adjustment is normally performed is illustrated in FIGS. 16 through 18. FIG. 16 is an example of a characteristic of the phase adjustment circuit indicating the relationship between the TAP value 222 and the amount of delay of a phase of a clock. FIG. 17 is an example of a timing chart of an operation. FIG. 18 is an example of first and second phase adjustment results. When the phase adjustment is normally performed, a change in amount of delay of the delay line 401 (FIG. 4) indicates a monotonous increase when the TAP value 222 is changed as illustrated in FIG. 16, which is an ideal characteristic.

In the first phase adjustment, the adjustment pattern 301 is not inverted, and the timing is illustrated by (a) in FIG. 17. The clock waveform before the phase adjustment is illustrated by (b) in FIG. 17. The mark ○ indicates that the adjustment pattern has been detected, and the mark X indicates that no adjustment pattern has been detected. In this case, after the adjustment pattern has been successfully detected with the TAP value = 16, the TAP value 222 decreases, the TAP value = 14 is reached, the detection of the adjustment pattern fails, and the TAP lower limit = 15 is detected. Afterwards, when the TAP value 222 increases and the TAP value reaches 22, the detection of the adjustment pattern fails again, and the TAP upper limit = 21 is detected. The finally obtained phase-adjusted clock waveform is illustrated by (c) in FIG. 17. In this case, the final adjusted value of the TAP value is determined as (15+21)/2 = 18. In addition, the adjustment pattern detection frequency is the TAP value = 15 - 21, that is, seven times.

Next, in the second phase adjustment, the adjustment pattern 301 is inverted, and the timing is illustrated by (d) in FIG. 17. The clock waveform before the phase adjustment is illustrated by (e) in FIG. 17. In this case, after the adjustment pattern has been unsuccessfully detected with the TAP value = 16, the TAP value 222 increases, the TAP value = 23 is reached, the detection of the adjustment pattern is successfully performed, and the TAP lower limit = 23 is detected. Afterwards, when the TAP value 222 further increases and the TAP value reaches 30, the detection of the adjustment pattern fails, and the TAP upper limit = 29 is detected. The finally obtained phase-adjusted clock waveform is illustrated by (f) in FIG. 17. In this case, the final adjusted value of the TAP value is determined as (23+29)/2 =26. In addition, the adjustment pattern detection frequency is the TAP value = 23 ∼ 29, that is, seven times.

As a result of the first and second phase adjustments above, as illustrated in FIG. 18, the absolute value of the difference between the first and second final adjusted values of the TAP value is 8, which ranges from 6 to 10, and refers to a normal operation. The absolute value of the difference between the first and second adjustment pattern detection frequencies is 0, which ranges from 0 to 4, and refers to a normal operation. Thus, it is determined that the phase adjustment is normally performed.

An example of the case in which the phase adjustment is abnormal is illustrated in FIGS. 19 through 21. FIG. 19 is an example of a characteristic of the phase adjustment circuit indicating the relationship between the TAP value 222 and the amount of phase delay of a clock. FIG. 20 is an example of a timing chart of the operation. FIG. 21 is an example of the first and second phase adjustment results. When the phase adjustment is abnormal, for example as illustrated in FIG. 19, the TAP values = 21 - 24 are faulty, and the amount of delay of the delay line 401 (FIG. 4) is not changed although the TAP value is changed in the range.

In the first phase adjustment, the adjustment pattern 301 is not inverted, and the timing is illustrated by (a) in FIG. 20. In addition, the clock waveform before the phase adjustment is illustrated by (b) in FIG. 20. In this case, after the detection of the adjustment pattern is successfully performed with the TAP value = 16, the TAP value 222 decreases, and when the TAP value reaches 14, the detection of the adjustment pattern fails, and the TAP lower limit = 15 is detected. Then, the TAP value 222 increases, but since the phase does not change due to the fault with the TAP value = 21 - 24, the detection of the adjustment pattern finally fails with the TAP value = 26 exceeding the original TAP value = 22 ((b) in FIG. 17), and the TAP upper limit = 25 is detected. The clock waveform after the finally obtained phase adjustment is illustrated by (c) in FIG. 20. In this case, the final adjusted value of the TAP value is determined as (15+25)/2=20. The adjustment pattern detection frequency is the TAP value = 15 ∼ 25, that is, eleven times, which refers to an abnormally high frequency.

Next, in the second phase adjustment, the adjustment pattern 301 is inverted, and the timing is illustrated by (d) in FIG. 20. In addition, the clock waveform before the phase adjustment is illustrated by (e) in FIG. 20. In this case, after the detection of the adjustment pattern is unsuccessfully performed with the TAP value = 16, the TAP value 222 increases, but since the phase does not change due to the fault with the TAP value = 21 - 24, the detection of the adjustment pattern is finally performed successfully with the TAP value = 27 exceeding the original TAP value = 23 (see (e) in FIG. 17), and the TAP lower limit = 27 is detected. Then, the TAP value 222 further increases, and the detection of the adjustment pattern does not fail with the TAP value = 31, but since no higher TAP value 222 exists, the TAP upper limit = 31 is detected. The clock waveform after the finally obtained phase adjustment is illustrated by (f) in FIG. 20. In this case, the final adjusted value of the TAP value is determined as (27+31)/2=29. The adjustment pattern detection frequency is the TAP value = 27 ∼ 31, that is, five times.

As a result of the first and second phase adjustments above, as illustrated in FIG. 21, the absolute value of the difference between the first and second final adjusted values of the TAP value is 9, which ranges from 6 to 10, and refers to a normal operation. The absolute value of the difference between the first and second adjustment pattern detection frequencies is 6, which refers to a large shift and does not range from 0 to 4, thereby indicating an abnormal operation. Thus, it is determined that the phase adjustment is abnormally performed.

An error of a clock adjustment circuit (phase adjustment circuit) in an LSI is hard to detect and the cause of the error is hard to designate because of low reproducibility. With the above-mentioned embodiment, the detection and the analysis of an error can be easily performed. As a result, a problem can be fast detected and the time required to make a search for a problem can be considerably shortened. For example, a defective product can be removed in an LSI unit test by a tester during the production of an LSI. In addition, an error can be avoided by diagnosing the error in the LSI prior to a practical operation when a system operation is performed. Furthermore, when an error occurs during the system operation, it can be immediately determined by performing a diagnosis again whether or not an error of a phase adjustment circuit has occurred.

FIG. 22 is a configuration of an embodiment of an LSI unit test using the transmission LSI and the reception LSI according to the embodiment above. In the embodiment, an LSI tester 2201 and a test board 2202 are connected through a transmission LSI 2203 and a test target LSI 2204, and a controller 2205 controls the transmission LSI 2203 and the test target LSI 2204. With the configuration, a transmission/reception circuit 2206 in the transmission LSI 2203 and the test target LSI 2204 is implemented with the same configuration as in FIG. 11. Then, the controller 2205 corresponds to the controller 1105 in FIG. 11.

During the production of an LSI, it is tested by the LSI tester whether or not the LSI is defective, but the characteristic of a clock adjustment circuit (phase adjustment circuit) can be known by the system according to the embodiment illustrated in FIG. 22, thereby successfully eliminating a defective product.

## Claims

1. A self-testing apparatus for testing a phase adjustment circuit (223) that adjusts a phase of a clock by inputting an adjustment pattern signal to an electronic circuit and performs a phase adjusting operation of stepwise changing a phase adjustment set value for a change of the phase of the clock for the operation of an electronic circuit while detecting the adjustment pattern signal, the self-testing apparatus comprising:
a signal inversion unit (1101) that inverts an adjustment pattern signal; **characterized by** further comprising
an adjustment result acquisition unit (1201) that acquires a first phase adjustment set value adjusted and obtained when a phase adjusting operation is performed in a state in which the adjustment pattern signal is not inverted, a first number of detection times of the adjustment pattern signal in a runtime of the phase adjusting operation, a second phase adjustment set value adjusted and obtained when the phase adjusting operation is performed in a state in which the adjustment pattern signal is inverted by the signal inversion unit (1101), and a second number of detection times of the adjustment pattern signal in the runtime of the phase adjusting operation; and
a phase adjusting operation test unit (1105) that tests an operating state of the phase adjusting circuit (223) by examining values of the obtained first and second phase adjustment set values and the obtained first and second detection number of times of the adjustment pattern.

2. The self-testing apparatus according to claim 1, wherein
the phase adjusting operation test unit (1105) tests whether the operating state of the phase adjusting circuit (223) is abnormal or not by comparing an absolute value of a difference between the obtained first and second phase adjustment set values with a first threshold.

3. The self-testing apparatus according to claim 1, wherein
the phase adjusting operation test unit (1105) tests whether the operating state of the phase adjusting circuit (223) is abnormal or not by comparing an absolute value of a difference between the obtained first and second number of detection times of the adjustment pattern with a second threshold.

4. A self-testing method for testing a phase adjustment circuit (223) that adjusts a phase of a clock by inputting an adjustment pattern signal to an electronic circuit and performs a phase adjusting operation of stepwise changing a phase adjustment set value for a change of the phase of the clock for the operation of an electronic circuit while detecting the adjustment pattern signal, the self-testing method **characterized by** comprising:
acquiring a first phase adjustment set value adjusted and obtained when a phase adjusting operation is performed in a state in which the adjustment pattern signal is not inverted, and a first number of detection times of the adjustment pattern signal in a runtime of the phase adjusting operation,
acquiring a second phase adjustment set value adjusted and obtained when the phase adjusting operation is performed in a state in which the adjustment pattern signal is inverted, and a second number of detection times of the adjustment pattern signal in the runtime of the phase adjusting operation; and
testing an operating state of the phase adjusting circuit (223) by examining values of the obtained first and second phase adjustment set values and the obtained first and second detection number of times of the adjustment pattern.

5. The self-testing method according to claim 4, wherein
the testing tests whether the operating state of the phase adjusting circuit (223) is abnormal or not by comparing an absolute value of a difference between the obtained first and second phase adjustment set values with a first threshold.

6. The self-testing method according to claim 4, wherein
the testing tests whether the operating state of the phase adjusting circuit (223) is abnormal or not by comparing an absolute value of a difference between the obtained first and second number of detection times of the adjustment pattern with a second threshold.

## Patentansprüche

1. Selbsttestgerät zum Testen einer Phasenanpassungsschaltung (223), die eine Phase eines Takts anpasst durch ein Eingeben eines Anpassungsmustersignals in eine elektronische Schaltung, und eine Phasenanpassungsoperation durchführt, bei der schrittweise ein Phasenanpassungseinstellwert für eine Änderung der Phase des Takts für die Operation einer elektronischen Schaltung geändert wird, während das Anpassungsmustersignal erfasst wird, wobei das Selbsttestgerät umfasst:
eine Signalinvertierungseinheit (1101), die ein Anpassungsmustersignal invertiert; **dadurch gekennzeichnet, dass** es ferner umfasst
eine Anpassungsergebniserlangeeinheit (1201), die einen ersten Phasenanpassungseinstellwert erlangt, angepasst und erhalten, wenn eine Phasenanpassungsoperation durchgeführt wird, in einem Zustand, in dem das Anpassungsmustersignal nicht invertiert ist, eine erste Zahl von Erfassungen des Anpassungsmustersignals in einer Laufzeit der Phasenanpassungsoperation, einen zweiten Phasenanpassungseinstellwert, angepasst und erhalten, wenn die Phasenanpassungsoperation durchgeführt wird, in einem Zustand, in dem das Anpassungsmustersignal durch die Signalinvertierungseinheit (1101) invertiert ist, und eine zweite Zahl von Erfassungen des Anpassungsmustersignals in der Laufzeit der Phasenanpassungsoperation; und
eine Phasenanpassungsoperationstesteinheit (1105), die einen Operationszustand der Phasenanpassungsschaltung (223) testet, durch ein Prüfen von Werten der erhaltenen ersten und zweiten Phasenanpassungseinstellwerte und der erhaltenen ersten und zweiten Erfassungszahl des Anpassungsmusters.

2. Selbsttestgerät nach Anspruch 1, wobei die Phasenanpassungsoperationstesteinheit (1105) testet, ob der Operationszustand der Phasenanpassungsschaltung (223) anormal ist oder nicht, durch ein Vergleichen eines Absolutwerts einer Differenz zwischen den erhaltenen ersten und zweiten Phasenanpassungseinstellwerten mit einem ersten Schwellenwert.

3. Selbsttestgerät nach Anspruch 1, wobei die Phasenanpassungsoperationstesteinheit (1105) testet, ob der Operationszustand der Phasenanpassungsschaltung (223) anormal ist oder nicht, durch ein Vergleichen eines Absolutwerts einer Differenz zwischen der erhaltenen ersten und zweiten Zahl von Erfassungen des Anpassungsmusters mit einem zweiten Schwellenwert.

4. Selbsttestverfahren zum Testen einer Phasenanpassungsschaltung (223), die eine Phase eines Takts anpasst durch ein Eingeben eines Anpassungsmustersignals in eine elektronische Schaltung, und eine Phasenanpassungsoperation durchführt, bei der schrittweise ein Phasenanpassungseinstellwert für eine Änderung der Phase des Takts für die Operation einer elektronischen Schaltung geändert wird, während das Anpassungsmustersignal erfasst wird, wobei das Selbsttestverfahren **dadurch gekennzeichnet** ist, das es umfasst:
Erlangen eines ersten Phasenanpassungseinstellwerts, angepasst und erhalten, wenn eine Phasenanpassungsoperation durchgeführt wird, in einem Zustand, in dem das Anpassungsmustersignal nicht invertiert ist, und einer ersten Zahl von Erfassungen des Anpassungsmustersignals in einer Laufzeit der Phasenanpassungsoperation,
Erlangen eines zweiten Phasenanpassungseinstellwerts, angepasst und erhalten, wenn die Phasenanpassungsoperation durchgeführt wird, in einem Zustand, in dem das Anpassungsmustersignal invertiert ist, und einer zweiten Zahl von Erfassungen des Anpassungsmustersignals in der Laufzeit der Phasenanpassungsoperation; und
Testen eines Operationszustands der Phasenanpassungsschaltung (223), durch Prüfen von Werten der erhaltenen ersten und zweiten Phasenanpassungseinstellwerte und der erhaltenen ersten und zweiten Erfassungszahl des Anpassungsmusters.

5. Selbsttestverfahren nach Anspruch 4, wobei das Testen testet, ob der Operationszustand der Phasenanpassungsschaltung (223) anormal ist oder nicht, durch Vergleichen eines Absolutwerts einer Differenz zwischen den erhaltenen ersten und zweiten Phasenanpassungseinstellwerten mit einem ersten Schwellenwert.

6. Selbsttestverfahren nach Anspruch 4, wobei das Testen testet, ob der Operationszustand der Phasenanpassungsschaltung (223) anormal ist oder nicht, durch Vergleichen eines Absolutwerts einer Differenz zwischen der erhaltenen ersten und zweiten Zahl von Erfassungen des Anpassungsmusters mit einem zweiten Schwellenwert.

## Revendications

1. Appareil de test automatique destiné à tester un circuit de réglage de phase (223) qui règle une phase d'une horloge en appliquant un signal de motif de réglage à un circuit électronique, et met en oeuvre une opération de réglage de phase consistant à modifier progressivement une valeur de consigne de réglage de phase pour une modification de la phase de l'horloge en vue de l'exploitation d'un circuit électronique, tout en détectant le signal de motif de réglage, l'appareil de test automatique comprenant :
une unité d'inversion de signal (1101) qui inverse un signal de motif de réglage ; **caractérisé en ce qu'**il comprend en outre :
une unité d'acquisition de résultat de réglage (1201) qui acquiert une première valeur de consigne de réglage de phase réglée et obtenue lorsqu'une opération de réglage de phase est mise en oeuvre dans un état dans lequel le signal de motif de réglage n'est pas inversé, un premier nombre d'occurrences de détection du signal de motif de réglage pendant une durée d'exécution de l'opération de réglage de phase, une seconde valeur de consigne de réglage de phase réglée et obtenue lorsque l'opération de réglage de phase est mise en oeuvre dans un état dans lequel le signal de motif de réglage est inversé par l'unité d'inversion de signal (1101), et un second nombre d'occurrences de détection du signal de motif de réglage pendant la durée d'exécution de l'opération de réglage de phase ; et
une unité de test d'opération de réglage de phase (1105) qui teste un état d'exploitation du circuit de réglage de phase (223) en examinant des valeurs des première et seconde valeurs de consigne de réglage de phase obtenues et les premier et second nombres d'occurrences de détection obtenus du motif de réglage.

2. Appareil de test automatique selon la revendication 1, dans lequel
l'unité de test d'opération de réglage de phase (1105) teste si l'état d'exploitation du circuit de réglage de phase (223) est anormal ou non, en comparant une valeur absolue d'une différence entre les première et seconde valeurs de consigne de réglage de phase obtenues à un premier seuil.

3. Appareil de test automatique selon la revendication 1, dans lequel
l'unité de test d'opération de réglage de phase (1105) teste si l'état d'exploitation du circuit de réglage de phase (223) est anormal ou non, en comparant une valeur absolue d'une différence entre les premier et second nombres d'occurrences de détection obtenus, du motif de réglage, à un second seuil.

4. Procédé de test automatique destiné à tester un circuit de réglage de phase (223) qui règle une phase d'une horloge en appliquant un signal de motif de réglage à un circuit électronique, et met en oeuvre une opération de réglage de phase consistant à modifier progressivement une valeur de consigne de réglage de phase pour une modification de la phase de l'horloge en vue de l'exploitation d'un circuit électronique, tout en détectant le signal de motif de réglage, le procédé de test automatique étant **caractérisé en ce qu'**il consiste à :
acquérir une première valeur de consigne de réglage de phase réglée et obtenue lorsqu'une opération de réglage de phase est mise en oeuvre dans un état dans lequel le signal de motif de réglage n'est pas inversé, et un premier nombre d'occurrences de détection du signal de motif de réglage pendant une durée d'exécution de l'opération de réglage de phase ;
acquérir une seconde valeur de consigne de réglage de phase réglée et obtenue lorsque l'opération de réglage de phase est mise en oeuvre dans un état dans lequel le signal de motif de réglage est inversé, et un second nombre d'occurrences de détection du signal de motif de réglage pendant la durée d'exécution de l'opération de réglage de phase ; et
tester un état d'exploitation du circuit de réglage de phase (223) en examinant des valeurs des première et seconde valeurs de consigne de réglage de phase obtenues et les premier et second nombres d'occurrences de détection obtenus du motif de réglage.

5. Procédé de test automatique selon la revendication 4, dans lequel
le test teste si l'état d'exploitation du circuit de réglage de phase (223) est anormal ou non, en comparant une valeur absolue d'une différence entre les première et seconde valeurs de consigne de réglage de phase obtenues à un premier seuil.

6. Procédé de test automatique selon la revendication 4, dans lequel
le test teste si l'état d'exploitation du circuit de réglage de phase (223) est anormal ou non, en comparant une valeur absolue d'une différence entre les premier et second nombres d'occurrences de détection obtenus, du motif de réglage, à un second seuil.
